# EUROPEAN PATENT SPECIFICATION

(11) **EP 1 654 629 B1**
(45) Date of publication and mention of the grant of the patent: **19.01.2011**
(21) Application number: 03818138.4
(22) Date of filing: 14.08.2003
(51) Int. Cl.: G06F 1/32, H03K 3/012

(54) **MODIFYING CLOCK SIGNALS OUTPUT BY AN INTEGRATED CIRCUIT**
MODIFIZIEREN VON DURCH EINE INTEGRIERTE SCHALTUNG AUSGEGEBENEN TAKTSIGNALEN
MODIFICATION DE SIGNAUX DE SYNCHRONISATION PRODUITS PAR UN CIRCUIT INTEGRE

(43) Date of publication of application: 10.05.2006
(73) Proprietor: Infineon Technologies AG, 85579 Neubiberg (DE)
(72) Inventor: GOH, Ban Hok, Singapore 478930 (SG)
(74) Representative: White, Duncan Rohan
(86) International application number: PCT/SG2003/000193
(87) International publication number: WO 2005/017728

(56) References cited:
- US-A- 5 579 193
- US-A1- 2002 145 477
- PATENT ABSTRACTS OF JAPAN vol. 016, no. 392 (E-1251), 20 August 1992 (1992-08-20) & JP 04 127714 A (FUJITSU LTD;OTHERS: 01), 28 April 1992 (1992-04-28)

## Description

### Field of the invention

The present invention relates to an integrated circuit of the sort which is capable of generating and outputting a clock signal.

### Background of Invention

Some integrated circuits (ICs) are designed to output a clock signal, which can be provided to one or more other components of a system (e.g. a computer system), for example to ensure synchrony between the components. Some hardware designers make use of this feature, but others do not, especially in the case that the clock signal is at a fixed frequency, and therefore only has the function of ensuring synchrony. Yet other hardware designers use the clock signal to drive too many loads, overloading the capacity of the integrated circuit and creating clock-related problems such as clock jitter, i.e. an unstable clock which affects the signal integrity.

US5754069A discloses an integrated circuit in which a clock pulse generator sends clock signals to multiple drivers which amplify the clock pulses and transmit them off the chip through dedicated chip output terminals. In this disclosure, the clock signals are provided from the clock pulse generator to the drivers via respective gate units, and each of the drivers is associated with sensor circuitry which is operative to provide a cut-off signal to the respective gate. When it receives the cut-off signal, the gate stops transmitting the clock signal to the driver, which therefore stops the clock signal from being transmitted off-chip. In one of the embodiments discussed in the document, the sensor circuitry provides this cut-off signal to the gate when it senses that the line to which the clock output is connected is earthed, which for some hardware designs implies that there is no component attached to that clock output. This reduces both the chip's power consumption and unwanted EMI (electromagnetic interference). In other embodiments, the gate disables the clock outputs for a predefined period after power-up.

For example, the US Patent Application Publication no. US2002/0145477 relates to the problem of undesired power consumption in an oscillator during "stop" periods of a device is addressed by providing the oscillator in apparatus external to the device, the apparatus including a current sensor sensing current in a line between the apparatus and the device, the line communicating an oscillator "clock" signal. If the device enters a "stop" state the current flow during certain half-cycles of the oscillation is relatively low compared to the current flow in the "no-stop" state. In response to the relatively low current, the apparatus halts oscillation. Later, when the device exits the "stop" state, current flow increases in the line, and the apparatus resumes oscillation, thereby resuming the communication of the clock signal to the device. Alternatively the apparatus monitors two oscillator lines by means of an XOR gate, powering down the oscillator when the XOR output goes low and restoring the oscillator when the XOR output goes high.

### Summary of the Invention

The present invention aims to provide a new and useful integrated circuit which generates a clock-signal for transmission to other components.

In general terms, the present invention proposes that the integrated circuit is provided with a load measurement circuit which measures a load value indicative of the power load being drawn from the IC by the clock output, and a comparison circuit which compares the load value to one or more predetermined load threshold values. The integrated circuit stops transmitting the clock signal off-chip according to the result of the comparison.

Preferably, the predetermined load threshold values include at least a "high" load threshold value. If the measured load value is above this "high" load threshold value then the power drawn may be beyond the operational limits of the integrated circuit, such that the integrity of the computer system may be compromised, so the comparison circuit stops the integrated circuit transmitting the clock signal off-chip.

Preferably, the predetermined load threshold values also include a "low" load threshold value. If the measured load value is below this "low" load threshold value then this may indicate that the clock signal is unused. Thus, the comparison circuit turns off the clock signal to reduce power consumption by the integrated circuit and also the risk of EMI. The "low" load value may be selected to correspond to zero load, but may also be selected to correspond to a higher load. In contrast to the circuit disclosed in US5754069A, the concept of stopping the clock signal from being transmitted based on a measurement of load means that the clock signal is not transmitted unnecessarily even In situations in which the clock output is not connected to earth. This is indeed a common situation, since the clock signal may be fed to a circuit location which is at non-zero voltage but which for some reason is inactive, or to a location which carries a low amplitude signal irrelevant to the clock signal (e.g. a noise signal).

Preferably, the load measurement circuit comprises a resistive element in series with the clock output and a element for deriving a difference signal between the voltages at the respective sides of the resistive element.

Note that the mechanism for stopping the clock signal being transmitted varies in different embodiments of the invention. The comparison circuit may, for example, be arranged to be capable of turning off the clock pulse generator completely. Alternatively, the comparison circuit may be able to open a switch element between the clock pulse generator and the clock output (e.g. a switch between the clock pulse generator and a driver which amplifies the clock pulse before it is transmitted off-chip.)

The comparison circuit may be resettable, i.e. such that it can be made to revert into a state in which it permits the clock signal to be transmitted off-chip. It may be arranged to be resettable for example by a signal transmitted to it (e.g. by a timing circuit), or it may include its own reset circuit which resets it (e.g. a predetermined time after issuing the cut-off signal), so that a further measurement of the load may be made.

Specifically, the present invention proposes an integrated circuit having:
a clock signal generation unit for generating a clock signal
characterised by
the clock signal for transmission off the integrated circuit through a clock signal output pin,
a load measurement circuit which measures a load value indicative of the power load being drawn from the integrated circuit from the clock signal output pin, and
a comparison circuit for comparing the load value to one or more predetermined load thresholds and which is operative to prevent the clock signal from being transmitted through the clock signal output pin according to the result of the comparison.

### Brief Description of The Figures

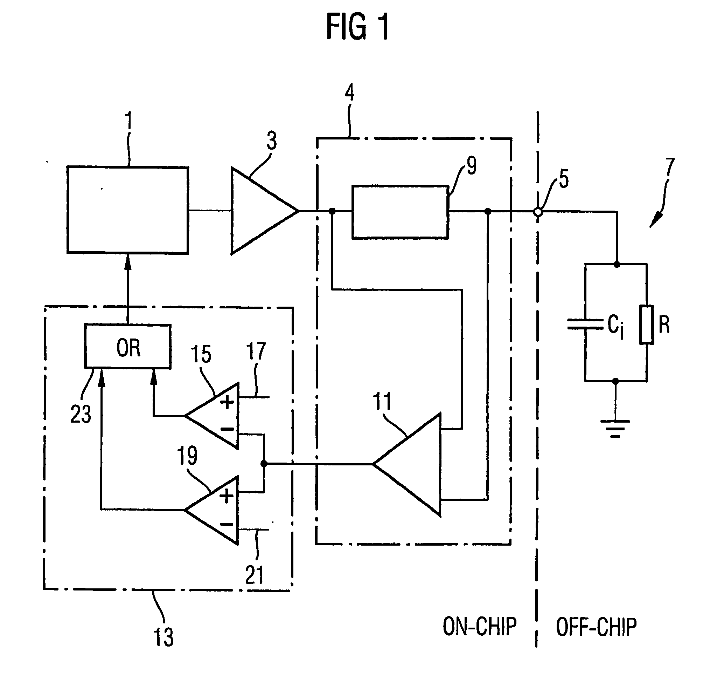

Preferred features of the invention will now be described, for the sake of illustration only, with reference to Figure 1 which shows schematically the configuration of clock signal generation circuit in an integrated circuit which is an embodiment of the invention.

### Detailed Description of the embodiment

Referring to Fig. 1, a clock signal generation circuit in an embodiment of the invention is illustrated. It includes a clock pulse generation unit 1 which generates a clock signal, and passes it to a driver (amplifier) 3. The driver passes the clock signal to a clock output pin 5 of the integrated circuit, from where it is transmitted to a load, indicated generally as 7. The load 7 may include a capacitative component Cₗ and a resistive component Rₗ. Generally, the capacitance is Cₗ is much more important than Rᵢ in determining the power load from the clock output pin 5 since Rₗ is typically very high when the load 7 is one or more integrated circuits.

In the embodiment, the driver 3 passes the clock signal to the clock output pin 5 via a load measurement circuit 4 including a sensing resistor 9. The voltages at the two sides of the resistor 9 are input to a differential amplifier 11, which outputs a load value which indicates the load being drawn by the load 7.

The load signal is input to a comparison circuit 13 including a first comparator 15 which compares the load signal to a "low" load threshold value 17. The output of the first comparator 15 is high if and only if the load value is below the "low" load threshold.

The comparison circuit 13 further includes a second comparator 19 which compares the load signal output by the differential amplifier 11 to a "high" load threshold value 21. The output of the second comparator 19 is high if and only if the load value is above the "high" load threshold.

The comparison circuit 13 further includes an OR gate 23, which receives the output of the comparators 15, 19, and transmits its output to the clock signal generation unit 1. In the case that the output of the OR gate 23 is logic high (indicating that the load value output by the differential amplifier is out of the range between the thresholds 17, 21), the clock signal generation unit 1 is designed to stop generating the clock signal.

The low load threshold value 17 is lower than the high load threshold value 21, and may be zero. However, more preferably, it corresponds to the load which would be expected if the load is non-zero, e.g. equal to the load value which would be obtained if the capacitance Cᵢ is 4pF (and Rₗ is infinite).

The designer of a system containing the integrated circuit may be permitted to change the values of the thresholds. This may be done, for example, if the threshold values 17, 21 are defined by writable memories in the integrated circuit (not shown in Fig. 1), which can be programmed by appropriate voltage inputs to the integrated circuit or even by software operations performed in the integrated circuit. The designer of the chip will typically select one or both of the threshold values 17, 21 by experimentation (e.g. when the operation of the circuit is simulated in software during a design stage).

The driver 3 generates a non-zero voltage when the clock generator is turned off, so that there is a load, and the comparison circuit can detect when the load changes to enter the range from "low" load to "high" load.

Although only a single embodiment of the invention has been described in detail, many variations are possible within the scope of the invention. For example, the output of the OR gate 23 may not be transmitted to the clock signal generator unit 1, but instead to a switch located between the clock signal generator unit 1 and the driver 3. The switch is arranged to transmit the clock signal from the clock signal generator unit 1 to the driver 3 if and only if the output of the OR gate 23 is low.

## Claims

1. An integrated circuit having:
a clock signal generation unit (1) for generating a clock signal
**characterised by**
the clock signal for transmission off the integrated circuit through a clock signal output pin (5),
a load measurement circuit (4) which measures a load value indicative of the power being drawn from the integrated circuit from the clock signal output pin (5), and
a comparison circuit (13) for comparing the load value to a predetermined low threshold and a predetermined high threshold, the comparison circuit (13) being arranged to prevent the clock signal from being transmitted through the clock signal output pin (5) when the load value is above the high threshold or below the low threshold, the low and high thresholds being settable according to the integrated circuit operational limits.

2. An Integrated circuit according to claim 1 in which the load measurement circuit (4) comprises a resistive element (9) in series with the clock signal output pin (5) and a differential amplifier (11) for deriving a difference signal between the voltages at the sides of the resistive element (9).

3. An integrated circuit according to any preceding claim further comprising a writable memory unit for storing the predetermined load thresholds.

4. A system comprising an integrated circuit according to any preceding claim and one or more load elements (7) arranged to receive the clock signal from the clock signal output pin (5).

## Patentansprüche

1. Integrierte Schaltung, aufweisend:
eine Taktsignal-Erzeugungseinheit (1), um ein Taktsignal zu erzeugen
**gekennzeichnet durch**
das Taktsignal für eine Übertragung aus der integrierten Schaltung **durch** einen Taktsignal-Ausgangspin (5),
eine Lastmessschaltung (4), die einen Lastwert misst, der den Strom angibt, der von der integrierten Schaltung vom Taktsignal-Ausgangspin (5) verbraucht wird, und
eine Vergleichsschaltung (13), um den Lastwert mit einem vorherbestimmten niedrigen Schwellenwert und einem vorherbestimmten hohen Schwellenwert zu vergleichen, wobei die Vergleichsschaltung (13) angeordnet ist, um zu verhindern, dass das Taktsignal **durch** den Taktsignal-Ausgangspin (5) übertragen wird, wenn der Lastwert über dem hohen Schwellenwert oder unter dem niedrigen Schwellenwert liegt, wobei der hohe und niedrige Schwellenwert in Bezug auf die Betriebsgrenze der integrierten Schaltung einstellbar sind.

2. Integrierte Schaltung nach Anspruch 1, wobei die Lastmessschaltung (4) ein Widerstandselement (9) in Serie mit dem Taktsignal-Ausgangspin (5) umfasst und einen Differentialverstärker (11), um ein Differenzsignal zwischen den Spannungen an den jeweiligen Seiten des Widerstandselements (9) abzuleiten.

3. Integrierte Schaltung nach einem der vorhergehenden Anspruche, ferner umfassend eine beschreibbare Speichereinheit zum Speichern der vorherbestimmten Last-Schwellenwerten.

4. System, umfassend eine integrierte Schaltung nach einem der vorhergehenden Ansprüche und ein oder mehrere Lastelemente (7), die angeordnet sind, um das Taktsignal vom Taktsignal-Ausgangspin (5) zu empfangen.

## Revendications

1. Circuit intégré possédant :
- une unité de génération de signal de synchronisation (1) pour générer un signal de synchronisation ;
**caractérisé par** :
- le signal de synchronisation pour une transmission en sortie du circuit intégré par l'intermédiaire d'une broche de sortie de signal de synchronisation (5) ;
- un circuit de mesure de charge (4) qui mesure une valeur de charge indiquant la puissance extraite du circuit intégré à partir de la broche de sortie de signal de synchronisation (5) ; et
- un circuit de comparaison (13) pour comparer la valeur de charge à un seuil inférieur prédéterminé et un seuil supérieur prédéterminé, le circuit de comparaison (13) étant agencé pour empêcher le signal de synchronisation d'être transmis par l'intermédiaire de la broche de sortie de signal de synchronisation (5) lorsque la valeur de charge est en dessus du seuil supérieur ou en dessous du seuil inférieur, les seuils inférieur et supérieur pouvant être établis selon les limites de fonctionnement du circuit intégré.

2. Circuit intégré selon la revendication 1, dans lequel le circuit de mesure de charge (4) comprend un élément résistif (9) monté en série avec la broche de sortie de signal de synchronisation (5) et un amplificateur différentiel (11) pour dériver un signal de différence entre les tensions aux bornes de l'élément résistif (9).

3. Circuit intégré selon l'une quelconque des revendications précédentes, comprenant, de plus, une unité de mémoire inscriptible pour stocker les seuils prédéterminés de charge.

4. Système comprenant un circuit intégré selon l'une quelconque des revendications précédentes et un ou plusieurs éléments de charge (7) agencés pour recevoir le signal de synchronisation à partir de la broche de sortie de signal de synchronisation (5).
